# EUROPÄISCHE PATENTSCHRIFT

(11) **EP 3 631 818 B1**
(45) Veröffentlichungstag und Bekanntmachung des Hinweises auf die Patenterteilung: **18.11.2026**
(21) Anmeldenummer: 18726809.9
(22) Anmeldetag: 24.05.2018
(51) Int. Cl.: H01C 3/00, H01C 1/144, H01C 13/02, H01C 7/06, H01C 1/012, H01C 1/02, H02H 9/02, G01K 7/22, H01C 1/014, H02H 3/05, H02H 9/00

(54) **ELEKTRISCHES BAUTEIL MIT SICHERUNGSELEMENT**
ELECTRIC COMPONENT WITH SAFETY ELEMENT
COMPOSANT ÉLECTRIQUE DOTÉ D'UN ÉLÉMENT DE SÉCURITÉ

(30) Priorität: 24.05.2017 DE 102017111415
(43) Veröffentlichungstag der Anmeldung: 08.04.2020
(73) Patentinhaber: TDK Electronics AG, 81671 München (DE)
(72) Erfinder: HOFRICHTER, Alfred, 8230 Hartberg (AT); WISCHNAT, Volker, 8530 Deutschlandsberg (AT); PICHLER, Johann, 8614 Breitenau am Hochlantsch (AT)
(74) Vertreter: Epping - Hermann - Fischer
(86) Internationale Anmeldenummer: PCT/EP2018/063629
(87) Internationale Veröffentlichungsnummer: WO 2018/215587

(56) Entgegenhaltungen:
- EP-A2- 0 203 350
- EP-A2- 0 836 201
- KR-B1- 101 451 554
- US-A1- 2006 176 675

## Beschreibung

Die vorliegende Erfindung betrifft ein elektrisches Bauteil aufweisend ein Funktionselement und ein Sicherungselement. Beim Funktionselement handelt es sich beispielsweise um einen Kaltleiter (PTC-Element, englisch *positiv temperature coefficient) oder um einen Heißleiter* (NTC-Element, englisch *negative temperature coefficient*). Das Sicherungselement ist dazu ausgebildet, bei einem Ausfall des elektrischen Funktionselements eine Grundfunktionalität aufrecht zu erhalten.

Elektrische Bauelemente wie z.B. keramisch Bauelemente, Schutzbauelemente oder Heizelemente können aus verschiedenen Gründen ausfallen. Beispielsweise kann ein Ausfall bei mechanischer Belastung, Überstrom oder Materialermüdung auftreten. Dies kann zu einem Kurzschluss oder zu einer Kontakttrennung ("open") des Bauelements führen, was wiederum, abhängig vom Einsatz des Bauelements zu Funktionsausfall und unter Umständen zu sicherheitsrelevanten Störungen führen kann. Diese Störungen müssen gegebenenfalls durch aufwändige technische Lösungen, beispielsweise Überwachungssysteme oder Relais, abgefangen werden.

Die EP 0 203 350 A2 offenbart eine Temperaturmessvorrichtung, aufweisend einen temperaturabhängigen NTC-Widerstand, der in Reihe zu einer Parallelschaltung aus einem hochohmigen Vorwiderstand und einem niederohmigen Vorwiderstand an eine Konstantspannungsquelle angeschlossen ist. Der Zweig zum niederohmigen Vorwiderstand wird mit fester Tastfrequenz unterbrochen. Dadurch soll ein Bruch oder Kurzschluss der Leitung zum NTC-Widerstand zuverlässig erkannt werden kann.

Die KR 101 451 554 B1 offenbart einen scheibenförmigen Thermistor, der mit einem Widerstand parallel oder seriell verschaltet ist, um einen Gesamtwiderstandswert einzustellen.

Die EP 0836201 A2 offenbart einen Strombegrenzer aufweisend einen Kaltleiter, der parallel mit einem ohmschen Widerstand und einem Varistor verschaltet ist, um eine Überlastung des Kaltleiters bei hoher Spannung verhindert werden.

Die US 2006/176675 A1 offenbart ein schichtförmiges PTC-Element, das seriell mit einem schichtförmigen WiderstandsElement verschaltet ist.

Es ist eine Aufgabe der vorliegenden Erfindung, ein elektrisches Bauteil mit verbesserten Ausfall-Eigenschaften anzugeben.

Gemäß einem ersten Aspekt der vorliegenden Erfindung wird ein elektrisches Bauteil aufweisend ein Funktionselement und ein dazu elektrisch verschaltetes Sicherungselement angegeben.

Das Sicherungselement gewährleistet bei einem Ausfall des Funktionselements einen Mindestwiderstand und/oder eine Mindestleitfähigkeit des Bauteils. Somit gewährleistet das Sicherungselement bei Ausfall des Funktionselements eine Grundfunktionalität des Bauteils. Beispielsweise kann dadurch eine sicherheitsrelevante Störung oder ein vollständiger Funktionsausfall vermieden oder zumindest verzögert oder abgeschwächt werden.

Beim Funktionselement handelt es sich beispielsweise um einen Kaltleiter oder um einen Heißleiter. Das Funktionselement weist beispielsweise ein keramisches Material auf. Das Funktionselement weist beispielsweise die Form einer Scheibe auf. Das Funktionselement kann auch eine andere Form aufweisen, beispielsweise die Form eines Quaders, eines Zylinders. Das Funktionselement kann ein Loch zur Befestigung oder elektrischen Kontaktierung aufweisen.

Das Funktionselement bzw. das gesamte Bauteil kann als Temperatursensor oder Temperaturregler ausgebildet sein. Das Funktionselement bzw. das gesamte Bauteil kann auch zur Begrenzung eines Einschaltstroms (ICL-Bauelement, englisch *Inrush Current Limiter*) ausgebildet sein. Es kann auch als Ableiter ausgebildet sein.

Bei einem Ausfall des Funktionselements ist beispielsweise kein ohmscher Kontakt über das Funktionselement mehr vorhanden, so dass der Widerstand des Bauteils ohne das Sicherungselement "unendlich" bzw. sehr groß wäre. Diese Ausfallart kann auch als Kontakttrennung oder "open" bezeichnet werden und tritt beispielsweise bei einem mechanischen Bruch des Funktionselements oder bei Ablösung elektrischer Kontakte auf. In bestimmten Anwendungen können jedoch eine Minimalleitfähigkeit und ein Minimalstrom über das Bauteil erforderlich sein, beispielsweise aus design- oder anwendungsbedingten Gründen. Das Sicherungselement kann die Minimalleitfähigkeit gewährleisten.

Ein Ausfall des Funktionselements kann auch als Kurzschluss auftreten. In diesem Fall stellt das Funktionselement keinen oder nur einen geringen Widerstand bereit, so dass ein hoher Stromfluss über das Funktionselement auftreten kann. Um Schädigungen durch den hohen Stromfluss zu vermeiden, kann das Sicherungselement in diesem Fall einen Minimalwiderstand bereitstellen.

In einer Ausführungsform ist das Sicherungselement parallel zum Funktionselement verschaltet. In diesem Fall kann das Sicherungselement eine Minimalleitfähigkeit im Fall einer Kontakttrennung ("open") des Funktionselements bereitstellen.

In einer alternativen Ausführungsform ist das Sicherungselement seriell zum Funktionselement verschaltet. In diesem Fall kann das Sicherungselement einen Minimalwiderstand im Fall eines Kurzschlusses des Funktionselements bereitstellen.

Es kann auch eine Kombination der beiden Ausführungsformen vorliegen. Beispielsweise ist ein Funktionselement mit einem ersten Sicherungselement parallel verschaltet und mit einem zweiten Sicherungselement seriell verschaltet. Das erste Sicherungselement kann eine Minimalleitfähigkeit und das zweite Sicherungselement einen Minimalwiderstand bereitstellen.

Von Vorteil ist es, wenn das Sicherungselement weniger ausfallanfällig ist als das Funktionselement. Zudem ist es von Vorteil, wenn das Sicherungselement eine einfache und kostengünstige Bauform aufweist.

In einer Ausführungsform ist das Sicherungselement als Drahtabschnitt ausgebildet. Der Widerstand des Sicherungselements wird dann durch geeignete Auswahl des Materials, der Länge und des Querschnitts des Drahts festgelegt. Alternativ dazu ist das Sicherungselement als Ohmsches Widerstandsbauelement ausgebildet. Beispielsweise weist das Sicherungselement ein keramisches Material auf. Das Sicherungselement kann auch als geeignet dimensioniertes PTC-Element ausgebildet sein.

Das Sicherungselement weist beispielsweise einen weitgehend temperaturunabhängigen Widerstand auf. Dies bedeutet, dass der Widerstand zumindest in einem betrachteten Temperaturbereich, beispielsweise von -50°C bis 150°C, ungefähr konstant ist. Ungefähr konstant bedeutet beispielsweise, dass der Widerstand in diesem Temperaturbereich vom Wert bei 25°C um maximal 20%, insbesondere um maximal 5% abweicht. Der relevante Temperaturbereich kann vom Anwendungsgebiet abhängen. Beispielsweise können auch Temperaturbereiche von - 25°C bis 125°C oder von -70°C bis 250°C/300°C betrachtet werden.

Das Funktionselement weist beispielsweise einen temperaturabhängigen Widerstand, insbesondere stark temperaturabhängigen Widerstand, auf. Beispielsweise nimmt der Widerstand bei steigender Temperatur in einem bestimmten Temperaturbereich stark zu (PTC-Element) oder stark ab (NTC-Element). Eine starke Temperaturabhängigkeit bedeutet beispielsweise, dass der Widerstand im betrachteten Temperaturbereich vom Wert bei 25 °C an mindestens einer Stelle, in einem Bereich oder ab einer bestimmten Temperatur um mindestens 100% abweicht.

Das Sicherungselement kann auch einen temperaturabhängigen Widerstand aufweisen. Beispielsweise ist das Sicherungselement als Kaltleiter ausgebildet.

Der Widerstand des Sicherungselements kann im Hinblick auf die gewünschten Eigenschaften des Bauteils optimiert sein. Beispielsweise kann das Sicherungselement derart dimensioniert sein, dass es bei Normalbetrieb, d.h., ohne Ausfall des Funktionselements, zum Gesamtwiderstand oder zur Gesamtleitfähigkeit des Bauteils nur wenig beiträgt.

Beispielsweise kann bei einer parallelen Verschaltung bei einer ausgewählten Temperatur, beispielsweise bei 25°C, der Widerstand des Sicherungselements gleich oder größer gewählt sein als der Widerstand des Funktionselements. Beispielsweise ist der Widerstand des Sicherungselements wesentlich größer als der Widerstand des Funktionselements. Beispielsweise ist bei 25°C der Widerstand des Sicherungselements mindestens doppelt so groß wie der Widerstand des Funktionselements. Der Widerstand des Sicherungselements kann auch um mindestens eine Größenordnung größer sein als der Widerstand des Funktionselements. Der Widerstand kann auch im gesamten relevanten Temperaturbereich, beispielsweise von -50°C bis 150°C, gleich oder größer sein.

Beispielsweise ist bei einer seriellen Verschaltung der Widerstand des Sicherungselements bei einer ausgewählten Temperatur, beispielsweise bei 25°C, wesentlich kleiner als der Widerstand des Funktionselements. Beispielsweise ist bei 25°C der Widerstand des Sicherungselements höchstens halb so groß wie der Widerstand des Funktionselements. Der Widerstand des Sicherungselements kann auch um mindestens eine Größenordnung kleiner sein als der Widerstand des Funktionselements. Der Widerstand kann auch im gesamten relevanten Temperaturbereich, beispielsweise von -50°C bis 150°C, gleich oder kleiner sein.

Das Sicherungselement kann auch derart dimensioniert sein, dass bei einer ausgewählten Temperatur der Gesamtwiderstand des Bauteils möglichst wenig vom Widerstand des Funktionselements abweicht. Beispielsweise ist die Abweichung bei einer Temperatur von größer als 0°C kleiner 10 %.

Zusätzlich dazu kann das Sicherungselement derart dimensioniert sein, dass es auch ohne Ausfall des Funktionselements positive Auswirkungen auf die gesamte elektrische Charakteristik hat.

Beispielsweise kann durch ein entsprechend dimensioniertes Sicherungselement der Widerstand bei niedriger Temperatur verringert werden. Auf diese Weise kann der Stromverlust bei Einschaltvorgängen im niedrigen Temperaturbereich reduziert und damit die Verlustleistung vermindert werden. Beispielsweise ist das Sicherungselement mit einem NTC-Element parallel verschaltet. Beispielsweise ist bei einer Temperatur von kleiner gleich -40°C der Widerstand des Sicherungselements kleiner gleich dem Widerstand des Funktionselements. Die relevante Temperatur kann vom Anwendungsgebiet abhängen. Eine entsprechende Dimensionierung kann auch bei serieller Verschaltung vorteilhaft sein.

In einer Ausführungsform ist das Funktionselement in Form einer Scheibe ausgebildet. Das Funktionselement weist beispielsweise eine Keramik auf. Zur elektrischen Kontaktierung sind beispielsweise Zuleitungen in Form von Drähten vorgesehen. Die Zuleitungen können parallel zueinander verlaufen. Die Zuleitungen sind beispielsweise mit dem Funktionselement verlötet. Das Funktionselement mit Zuleitungen eignet sich beispielsweise zur Leiterplattenmontage.

In einer nicht von den Ansprüchen umfassten Bauform ist bei paralleler Verschaltung das Sicherungselement als geeignet dimensioniertes Drahtstück ausgebildet. Insbesondere kann das Sicherungselement als Drahtabschnitt ausgebildet sein, der die Zuleitungen direkt miteinander verbindet und somit eine Drahtbrücke zwischen den Zuleitungen herstellt. Alternativ dazu kann das Sicherungselement auch in Form eines Ohmschen Bauelements in einer Verbindung der Zuleitungen angeordnet sein. Das Sicherungselement kann auch als geeignet dimensioniertes PTC-Element ausgebildet sein.

In einer nicht von den Ansprüchen umfassten Bauform ist bei serieller Verschaltung das Sicherungselement beispielsweise als Draht ausgebildet, der zumindest einen Teil einer Kontaktierung bildet. Beispielsweise ist ein Drahtabschnitt in einer Zuleitung angeordnet oder bildet vollständig eine Zuleitung. In diesem Fall unterscheidet sich der spezifische Widerstand des Drahtabschnitts beispielsweise vom spezifischen Widerstand der Zuleitung. Bei vollständiger Bildung einer Zuleitung unterscheidet sich der spezifische Widerstand des Drahtabschnitts beispielsweise vom spezifischen Widerstand der anderen Zuleitung.

In einer Ausführungsform ist das Funktionselement und/oder das gesamte Bauteil zur Oberflächenmontage ausgebildet. In einer nicht von den Ansprüchen umfassten Bauform ist das Sicherungselement beispielsweise an der Oberfläche des Funktionselements angeordnet, die bei Oberflächenmontage dem Träger zugewandt ist. In einer nicht von den Ansprüchen umfassten Bauform ist das ist das Sicherungselement in Form einer Platte ausgebildet, die zwischen Außenkontakten des Funktionselements und dem Träger angeordnet ist.

Erfindungsgemäß ist das Sicherungselement als Träger ausgebildet, wobei der Träger die Form einer Stange aufweist, auf die das Funktionselement und Kontaktierungen des Funktionselements aufgeschoben sind.

Das Sicherungselement kann zusätzlich zur Gewährleistung eines Minimalwiderstands oder einer Minimalleitfähigkeit auch zur Anzeige eines Ausfalls des Funktionselements und/oder zur Initiierung eines Fehlermodus ausgebildet sein. Dazu wird beispielsweise der Gesamtwiderstand des Bauteils gemessen. Abhängig von Verschaltung und Ausfallart kann beispielsweise ein Ausfall daran erkannt werden, dass der Gesamtwiderstand dem Widerstand des Sicherungselements entspricht.

Das Bauteil kann auch mehrere Funktionselemente aufweisen. Beispielsweise weist das Bauteil ein Sicherungselement auf, das mit mehreren Funktionselementen parallel oder seriell verschaltet ist. In diesem Fall kann das Sicherungselement einen Minimalstrom oder einen Minimalwiderstand bei Ausfall eines oder mehrerer der Funktionselemente gewährleisten.

Es können auch mehrere Sicherungselemente vorhanden sein, die jeweils mit einem oder mehreren Funktionselementen parallel oder seriell verschaltet sind. Beispielsweise ist jedem Funktionselement wenigstens ein oder genau ein Sicherungselement zugeordnet. Auch hier kann bei geeigneter Dimensionierung der Sicherungselemente durch Messung des Gesamtwiderstands erkannt werden, dass ein Funktionselement ausgefallen ist. Bei entsprechender Dimensionierung kann auch erkannt werden, welches der Funktionselemente ausgefallen ist.

Gemäß einem weiteren Aspekt der vorliegenden Erfindung wird ein Verfahren zur Herstellung des oben beschriebenen Bauteils angegeben. Dabei wird ein Funktionselement bereitgestellt. Es wird eine Temperatur oder ein Temperaturbereich festgelegt, bei dem das Sicherungselement einen bestimmten Widerstand aufweisen soll. Beispielsweise wird ein Temperaturbereich festgelegt, in dem das Funktionselement besonders ausfallträchtig ist. Dann wird ein Sicherungselement bereitgestellt, dessen Widerstand bei der festgelegten Temperatur einen gewählten Wert annimmt, beispielsweise bei 25°C oder bei einer niedrigen Temperatur wie oben beschrieben.

Gemäß einem weiteren Aspekt der vorliegenden Erfindung wird eine Bauteilanordnung aufweisend wenigstens zwei der oben beschriebenen Bauteile angegeben. Die Bauteilanordnung kann auch als ein Bauteil mit mehreren Funktionselementen und Sicherungselementen betrachtet werden.

Gemäß einem weiteren Aspekt der vorliegenden Erfindung wird ein Verfahren zur Detektierung eines Ausfalls eines Funktionselements bei dem oben beschriebenen Bauteil angegeben. Dabei wird der Gesamtwiderstand des Bauteils gemessen. Der Gesamtwiderstand wird mit dem errechneten Gesamtwiderstand bei Ausfall des Funktionselements verglichen. Falls der Gesamtwiderstand des Bauteils dem errechneten Gesamtwiderstand bei Ausfall des Funktionselements entspricht, wird ein Ausfall angezeigt. Alternativ oder zusätzlich dazu wird ein Fehlermodus initiiert.

In der vorliegenden Offenbarung sind mehrere Aspekte einer Erfindung beschrieben. Alle Eigenschaften, die in Bezug auf das Bauteil, die Bauteilanordnung oder eines der Verfahren offenbart sind, sind auch entsprechend in Bezug auf den anderen Aspekt offenbart, auch wenn die jeweilige Eigenschaft nicht explizit im Kontext des anderen Aspekts erwähnt wird.

Weiterhin ist die Beschreibung der hier angegebenen Gegenstände nicht auf die einzelnen speziellen Ausführungsformen beschränkt. Vielmehr können die Merkmale der einzelnen Ausführungsformen - soweit technisch sinnvoll - miteinander kombiniert werden.

Im Folgenden werden die hier beschriebenen Gegenstände anhand von schematischen Ausführungsbeispielen näher erläutert.

Es zeigen:
- Figur 1: eine Ausführungsform eines Bauteils im schematischen Schaltbild,
- Figur 2: eine Ausführungsform eines Bauteils gemäß Figur 1 in seitlicher Ansicht,
- Figur 3A: eine weitere Ausführungsform eines Bauteils gemäß Figur 1 in perspektivischer Teilansicht,
- Figur 3B: Teile der Ausführungsform des Bauteils gemäß Figur 3A in detaillierter Explosionsdarstellung,
- Figur 4: eine weitere Ausführungsform eines Bauteils gemäß Figur 1 in seitlicher Ansicht,
- Figur 5: eine weitere Ausführungsform eines Bauteils im schematischen Schaltbild,
- Figur 6: eine Ausführungsform eines Bauteils gemäß Figur 5 in seitlicher Ansicht,
- Figur 7: eine weitere Ausführungsform eines Bauteils im schematischen Schaltbild,
- Figuren 8: bis 14 Widerstands-Temperatur-Kennlinien verschiedener Funktionselemente, Sicherungselemente und Bauteile gemäß Figur 1 in einfach logarithmischer Darstellung bzw. in linearer Darstellung,
- Figur 15: eine Widerstands-Temperatur-Kennlinie eines Funktionselements in einfach logarithmischer Darstellung,
- Figur 16: eine Ausführungsform einer Bauteilanordnung mit mehreren Bauteilen gemäß Figur 1.

Vorzugsweise verweisen in den folgenden Figuren gleiche Bezugszeichen auf funktionell oder strukturell entsprechende Teile der verschiedenen Ausführungsformen.

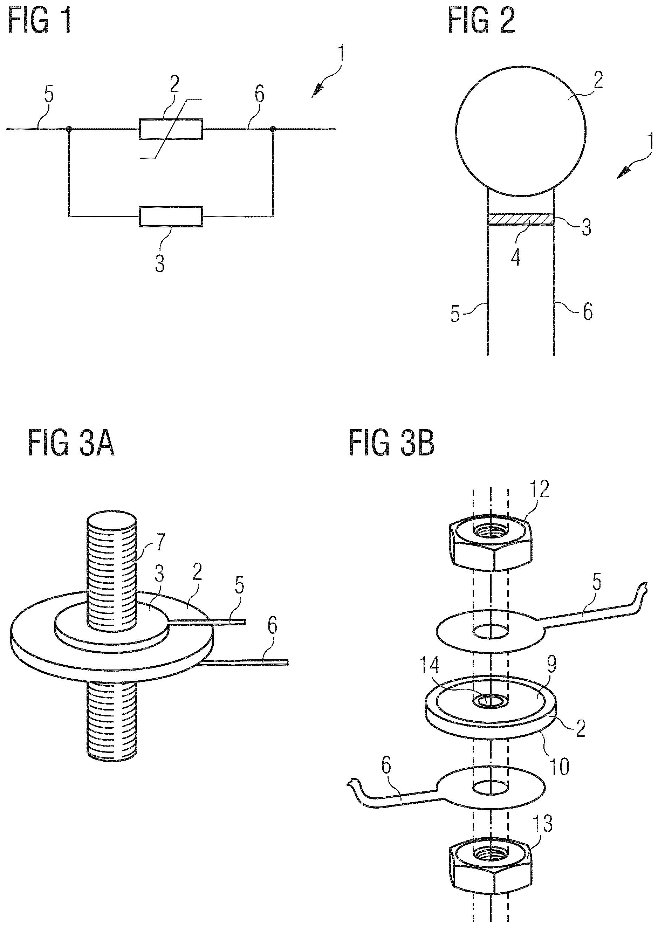

Figur 1 zeigt ein schematisches Schaltbild eines elektrischen Bauteils 1 aufweisend ein Funktionselement 2 und ein Sicherungselement 3. Bei dem Funktionselement 2 handelt es sich beispielsweise um ein keramisches Element. Es kann sich hierbei um ein Vielschichtbauelement handeln.

Das Funktionselement 2 weist beispielsweise einen stark temperaturabhängigen Widerstand auf. Das Funktionselement 2 kann als Heißleiter (NTC-Bauelement) ausgebildet sein. Das Funktionselement 2 bzw. das gesamte Bauteil 1 kann zur Begrenzung eines Einschaltstroms (ICL-Bauelement) ausgebildet sein. Das Funktionselement 2 kann auch als Varistor ausgebildet sein. Das Funktionselement 2 bzw. das gesamte Bauteil 1 kann auch als Ableiter ausgebildet sein.

Alternativ kann das Funktionselement 2 auch als Kaltleiter, (PTC-Element) ausgebildet sein. Beispielsweise dient das Funktionselement 2 bzw. das gesamte Bauteil 1 als Temperatursensor oder als Temperaturregler, insbesondere als Heizelement.

Zur Aufrechterhaltung eines Minimalstroms im Fall einer Kontakttrennung weist das Bauteil 1 ein Sicherungselement 3 (englisch *Fail Safe Element*) auf, das parallel zum Funktionselement 2 verschaltet ist. Insbesondere überbrückt das Sicherungselement 3 das Funktionselement 2 bei einer Kontakttrennung. Das Sicherungselement 3 weist einen derartigen Widerstand auf, dass im Normalbetrieb die Funktionsweise des Funktionselements 2 nicht oder nur wenig beeinträchtigt wird. Insbesondere erfüllt das Sicherungselement 3 die Funktion eines hochohmigen Leiters und kann beispielsweise als geeignet dimensioniertes Drahtstück oder ohmscher Widerstand ausgebildet sein. Das Sicherungselement 3 kann auch als geeignet dimensionierter Kaltleiter ausgebildet sein.

Das Sicherungselement 3 stellt eine Überbrückung zwischen elektrischen Kontaktierungen 5, 6 des Funktionselements 2 her. Bei den Kontaktierungen 5, 6 kann es sich beispielsweise um Zuleitungen oder um Außenkontakte des Funktionselements 2 handeln.

Der Gesamtwiderstand Rₜₒₜ des Bauteils 1 ergibt sich aus dem Widerstand R_{F} des Funktionselements 2 und dem Widerstand R_{S} des Sicherungselements 3 durch 1/Rₜₒₜ=1/R_{F} + 1/R_{S}.

Die Größe des Widerstands R_{S} des Sicherungselements 3 ist beispielsweise bei 25°C wesentlich größer als der Widerstand R_{F} des Funktionselements 2, so dass der Widerstand Rₜₒₜ des gesamten Bauteils 1 bei Normaltemperatur nahe am Widerstand des Funktionselements 2 liegt. Beispielsweise wird eine maximale Abweichung von 10%, bei beispielsweise 25°C, erzielt.

Bei paralleler Verschaltung ist die Abweichung vom Gesamtwiderstand des Bauteils 1 zum Widerstand des Funktionselements 2 umso geringer, umso höher der Widerstand des Sicherungselements 3 ist.

Zudem kann das Sicherungselement 3 so gewählt sein, dass bei niedriger Temperatur sein Widerstand R_{S} kleiner oder gleich dem Widerstand des Funktionselements 2 ist. Beispielsweise liegt eine niedrige Temperatur bei kleiner oder gleich -40°C vor, beispielsweise wird hier ein Bereich von -55°C bis -40°C betrachtet. Es kann auch ein Bereich von kleiner oder gleich -25°C als niedrige Temperatur betrachtet werden, insbesondere ein Bereich von -55°C bis -25°C.

Auf diese Weise kann der Maximalwiderstand des Bauteils 1 über dem ausgewählten Temperaturbereich eingestellt werden. Bei paralleler Verschaltung ist der Maximalwiderstand des Bauteils 1 umso niedriger, umso niedriger der Widerstand des Sicherungselements 2 ist.

Somit ist der Gesamtwiderstand des Bauteils 1 bei niedrigen Temperaturen geringer als der Widerstand nur des Funktionselements 2, was zu einer geringeren Verlustleistung führt. Die Kennlinie kann dadurch bei kalten Temperaturen "linearisiert" werden. Somit kann das Sicherungselement 3 zusätzlich zu seiner Sicherungsfunktion auch die Eigenschaften des Bauteils 1 bzw. des Funktionselements 2 im normalen Betrieb verbessern.

Das Sicherungselement 3 kann zusätzlich zur Sicherungsfunktion auch ein Alarmsignal für den Ausfall oder für Schäden des Funktionselements 2 bereitstellen und/oder einen Fehlermodus für das Bauteil 1 oder ein übergeordnetes System initiieren. Dazu wird beispielsweise der Gesamtwiderstand des Bauteils 1 bestimmt. Falls der Gesamtwiderstand dem Widerstand des Sicherungselements 3 entspricht, kann dies als Signal für den Ausfall des Funktionselements 2 interpretiert werden.

Figur 2 zeigt eine Ausführungsform eines Bauteils 1 gemäß Figur 1, bei der ein Sicherungselement 3 parallel zu einem Funktionselement 2 verschaltet ist. Das Bauteil 1 dient beispielsweise zur Einschaltstrombegrenzung.

Bei dem Funktionselement 2 handelt es sich um einen scheibenförmigen NTC-Thermistor, der beispielsweise ein gesintertes Metalloxid aufweist und mit einer Außenmetallisierung versehen ist. Das Funktionselement 2 ist über Kontaktierungen 5, 6 in Form von Zuleitungen elektrisch kontaktiert. Die Kontaktierungen 5, 6 sind als Drähte ausgebildet, die parallel zueinander verlaufen und beispielsweise das Funktionselement 2 auch mechanisch tragen.

Das Sicherungselement 3 ist als Draht 4, insbesondere als Drahtbrücke, ausgebildet. Das Sicherungselement 3 verbindet die Kontaktierungen 5, 6 elektrisch und überbrückt das Funktionselement 2 im Fall eines Ausfalls durch Kontakttrennung. Das Sicherungselement 3 ist beispielsweise durch Löten oder Schweißen mit den Kontaktierungen 5, 6 verbunden.

Vorliegend ist das Sicherungselement 3 lediglich durch die Drahtbrücke gebildet. In einer alternativen Ausführungsform kann das Sicherungselement 3 ein Widerstandsbauteil aufweisen, das einen Ohmschen Widerstand bereitstellt. Das Widerstandbauteil ist beispielsweise über Anschlussdrähte mit den Kontaktierungen 5, 6 verbunden. Das Widerstandsbauteil weist beispielsweise einen keramischen Grundkörper auf.

Das Sicherungselement 3 ist mit dem Funktionselement 2 in einem Bauteil 1 realisiert. Insbesondere ist nur eine geringfügige Modifikation eines bekannten Bauteils ohne Sicherungselement 3, d.h. eines Bauteil aufweisend nur das Funktionselement 2 und die Kontaktierungen 5, 6 nötig. Somit kann ein bekanntest Bauteil kostengünstig mit einem Sicherungselement 3 versehen und wie gewohnt montiert werden.

Die Figuren 3A und 3B zeigen eine weitere Ausführungsform eines Bauteils 1 gemäß Figur 1, bei der ein Sicherungselement 3 parallel zu einem Funktionselement 2 verschaltet ist. Das Bauteil 1 ist beispielsweise als keramischer Einschaltstrombegrenzer ausgebildet. Figur 3A zeigt das Funktionselement 2, das Sicherungselement 3 und die Kontaktierungen 5, 6 schematisch, Figur 3B zeigt die Kontaktierung des Funktionselements 2 im Detail.

Das Funktionselement 2 ist in Form einer Scheibe mit Loch 14 ausgebildet. Das Funktionselement 2 kann auch eine andere Form aufweisen. Beidseitig weist das Funktionselement 2 Außenkontakte 9, 10 zur elektrischen Kontaktierung auf. Die Außenkontakte 9, 10 sind beispielsweise als Metallisierungen ausgebildet.

Das Sicherungselement 3 ist als Träger 7 für das Funktionselement 2 und/oder für die Kontaktierungen 5, 6 ausgebildet. Das Sicherungselement 3 weist beispielsweise einen hochohmigen Leiter, wie z.B. leitfähigen Kunststoff oder ein Metall mit geeignetem spezifischem Widerstand auf. Beispielsweise handelt es sich um Stahl.

Vorliegend ist das Sicherungselement 3 in Form einer Stange, insbesondere einer Gewindestange, ausgebildet, an der das Funktionselement 2 befestigt ist. Das Funktionselement 2 ist beispielsweise auf die Stange aufgeschoben. Das Sicherungselement 3 kann auch eine andere Form aufweisen.

Die Kontaktierungen 5, 6 sind beispielsweise beidseitig des Funktionselements 2 angeordnet und werden vom Sicherungselement 3 getragen. Beispielsweise weisen die Kontaktierungen 5, 6 scheibenförmige Kontaktelemente auf, die auf das Sicherungselement 3 aufgeschoben sind. Es handelt sich beispielsweise um Kupferkontakte. Die Kontaktierungen 5, 6 können insbesondere in Form von Kabelschuhen ausgebildet sein.

Die Kontaktierungen 5, 6 und/oder das Funktionselement 2 können durch Befestigungselemente 12, 13 am Sicherungselement 3 befestigt sein. Beispielsweise sind die Befestigungselemente 12, 13 als Muttern ausgebildet und auf das Sicherungselement 3 aufgeschraubt. Die Befestigungselemente 12, 13 können auch eine elektrische Verbindung der Kontaktierungen 5, 6 mit dem Sicherungselement 3 herstellen. Die Kontaktierungen 5, 6 können auch fest mit dem Funktionselement 2 verbunden, beispielsweise am Funktionselement 2 angelötet sein.

Die Kontaktierungen 5, 6 sind elektrisch leitend mit dem Sicherungselement 3 verbunden, so dass das Sicherungselement 3 eine Überbrückung bei einem Ausfall des Funktionselements 2 durch Kontakttrennung herstellt.

Alternativ dazu kann das Sicherungselement 3 auch als Gehäuse für das Funktionselement 2 oder als Gehäuseteil ausgebildet sein. In diesem Fall ist das Funktionselement 2 beispielsweise als Scheibe ohne Loch ausgebildet. Das Gehäuse oder Gehäuseteil bildet beispielsweise einen Schutz des Funktionselements 2 von außen. Das Gehäuse oder Gehäuseteil kann das Funktionselement 2 vollständig oder teilweise umschließen. Das Gehäuse oder Gehäuseteil kann direkt mit dem Funktionselement 2 verbunden sein. Alternativ ist das Gehäuse oder Gehäuseteil nicht direkt mit dem Funktionselement 2 verbunden.

Das Sicherungselement 3 kann außen zusätzlich mit einem Isolator, wie z.B. Lack, Kunststoff, Email oder einer Verglasung, versehen, beispielsweise beschichtet sein. Somit können elektrische Überschläge oder Leckströme aus Sicherheitsgründen vermieden werden. Darüber hinaus kann Korrosion zur Sicherstellung der Sicherungsfunktion vermieden werden.

Ferner kann das Sicherungselement 3 auch als alternative Befestigungsmöglichkeit für Bauteile wie z.B. PTC-, NTC- oder ICL-Scheiben realisiert sein.

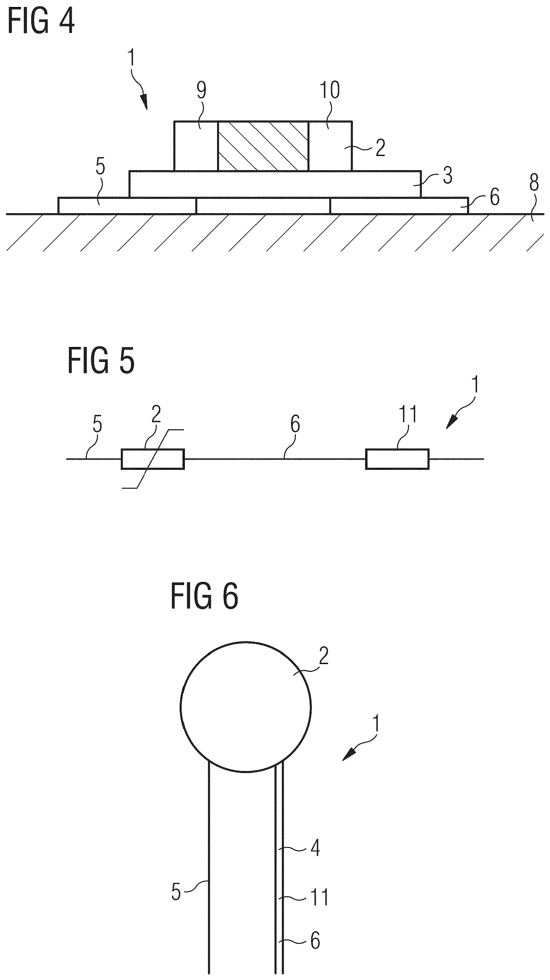

Figur 4 zeigt eine weitere Ausführungsform eines Bauteils 1 gemäß Figur 1, bei dem das Funktionselement 2 zur SMD (englisch *surface mountable device*) Montage ausgebildet ist.

Das Funktionselement 2 ist zur Anordnung auf einem Träger 8, beispielsweise einer Leiterplatte, ausgebildet. Auf dem Träger 8 sind Kontaktierungen 5, 6, beispielsweise in Form von Lötpads angeordnet. Auf den Kontaktierungen 5, 6 ist das Sicherungselement 3 angeordnet und verbindet die Kontaktierungen 5, 6 elektrisch. Auf dem Sicherungselement 3 ist das Funktionselement 2 angeordnet.

Beispielsweise ist das Sicherungselement 3 an das Funktionselement 2 angelötet und stellt eine hochohmige Verbindung zwischen Außenkontakten 9, 10 des Funktionselements 2 her. Beispielsweise ist das Sicherungselement 3 als metallische Widerstandsbrücke, z.B. in Form einer Platte, oder als ohmscher Widerstand ausgebildet.

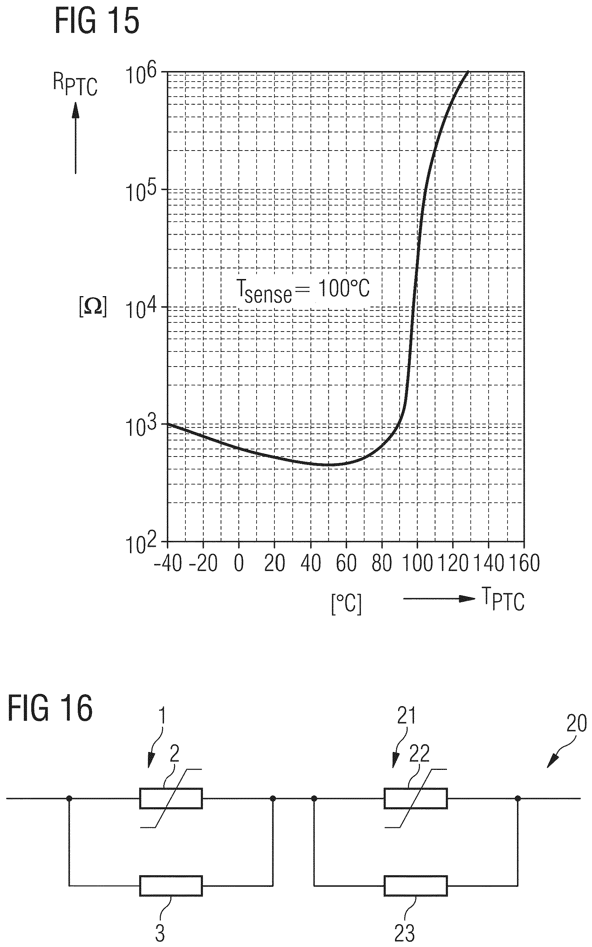

Figur 5 zeigt ein schematisches Schaltbild einer weiteren Ausführungsform eines Bauteils 1 aufweisend ein Funktionselement 2 und ein Sicherungselement 11. Bei dem Funktionselement 2 handelt es sich beispielsweise um einen Kaltleiter, d.h. um ein PTC-Element. Figur 15 zeigt eine Widerstands-Temperatur-Kennlinie eines beispielhaften PTC-Elements.

Im Falle eines Kurzschlusses des Funktionselements 2 bildet das Funktionselement 2 nur einen geringen oder keinen Widerstand, so dass ein hoher Stromfluss über das Funktionselement 2 auftreten kann. Um auch bei einem Kurzschluss einen ausreichenden Widerstand des Bauteils 1 zu gewährleisten, wird das Sicherungselement 11 seriell mit dem Funktionselement 2 verschaltet, beispielsweise dem Funktionselement 2 nachgeschaltet.

Das Sicherungselement 11 weist bei vorgesehenen Betriebstemperaturen einen geringen Widerstand auf. Als vorgesehene Betriebstemperatur werden beispielsweise Temperaturen bis zu 120 °C bezeichnet. Die vorgesehene Betriebstemperatur kann je nach verwendetem Funktionselement 2 variieren. Der Widerstand des Sicherungselements 11 ist beispielsweise bei einer vorgesehenen Betriebstemperatur deutlich geringer als der Widerstand des Funktionselements 2.

Beispielsweise weist das Sicherungselement 11 einen Widerstand von R_{S} = 10² Ohm auf. Das Sicherungselement 11 weist diesen Widerstand beispielsweise auch bei hohen Temperaturen, beispielsweise bei Temperaturen größer als 120°C auf. Bei einem Ausfall des Funktionselements 2 ohne Vorhandensein des Sicherungselements 11 würde der Widerstand Rₜₒₜ bei 0 Ohm liegen. Durch das Vorhandensein des Sicherungselements 11 liegt der Widerstand Rₜₒₜ bei 10² Ohm. Somit ist ein Minimalwiderstand des Bauteils 1 gewährleistet. Beispielsweise ist das Sicherungselement 11 als Kaltleiter-Element, insbesondere als keramisches PTC-Element, ausgebildet. Das Kaltleiter-Element weist beispielsweise bei einer üblichen Einsatztemperatur des Funktionselements 2 einen geringen Widerstand auf und weist bei hohen Temperaturen einen hohen Widerstand auf. Das Sicherungselement 11 kann auch einen Widerstand aufweisen, der über die Temperatur weitgehend konstant ist. Das Sicherungselement 11 kann beispielsweise aus einem Draht, insbesondere als Drahtwendel oder als geeignet dimensioniertes Drahtstück, ausgebildet sein.

Auch hier kann das Sicherungselement 11 zusätzlich zur Sicherungsfunktion ein Alarmsignal für den Ausfall oder für Schäden des Funktionselements 2 bereitstellen und/oder einen Fehlermodus für das Bauteil 1 oder ein übergeordnetes System initiieren. Falls der Gesamtwiderstand dem Widerstand des Sicherungselements 11 entspricht, kann dies als Signal für den Ausfall des Funktionselements 2 interpretiert werden.

Figur 6 zeigt eine Ausführungsform eines Bauteils 1 gemäß Figur 5, bei der ein Sicherungselement 11 seriell zu einem Funktionselement 2 verschaltet ist.

Bei dem Funktionselement 2 handelt es sich beispielsweise um einen scheibenförmigen PTC-Thermistor, der beispielsweise ein gesintertes Metalloxid aufweist und mit einer Außenmetallisierung versehen ist. Das Funktionselement 2 ist über Kontaktierungen 5, 6 elektrisch kontaktiert. Die Kontaktierungen 5, 6 sind wie in Figur 2 als Drähte ausgebildet, die parallel zueinander verlaufen und das Funktionselement 2 auch tragen.

Eine Kontaktierung 6 ist zugleich als Sicherungselement 11 ausgebildet. Das Sicherungselement 11 kann auch nur einen Teil der Kontaktierung 6 bilden oder als separates Element mit der Kontaktierung 6 verbunden sein. Das Sicherungselement 11 ist beispielsweise als geeignet dimensioniertes Drahtstück 4 oder als separater Ohmscher Widerstand ausgebildet. Der spezifische Widerstand des Sicherungselements 11 ist größer als der spezifische Widerstand der anderen Kontaktierung 5.

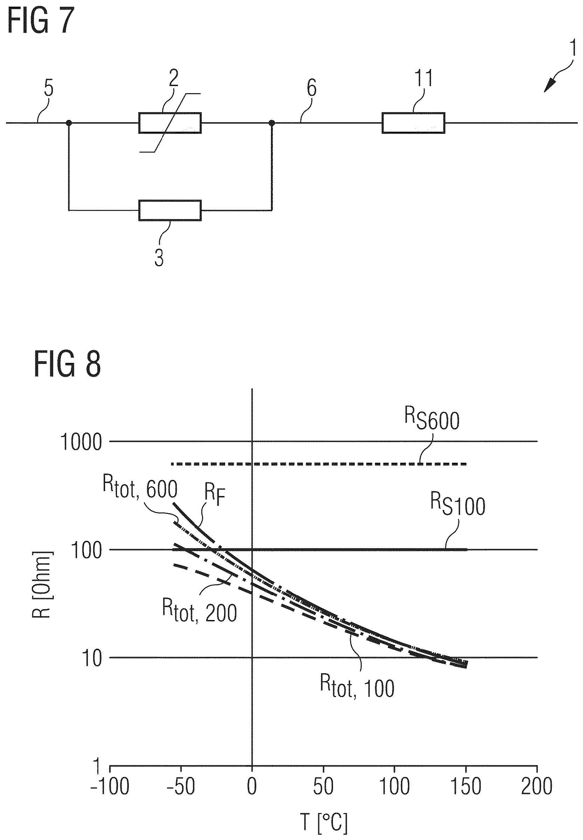

Figur 7 zeigt ein schematisches Schaltbild eines weiteren Bauteils 1 aufweisend ein Funktionselement 2 und zwei Sicherungselemente 3, 11, wobei ein Sicherungselement 3 parallel und das andere Sicherungselement 11 seriell mit dem Funktionselement 2 verschaltet ist. Es handelt sich somit um eine Kombination der Ausführungsformen der Figuren 1 und 5.

Durch das parallel verschaltete Sicherungselement 3 wird sichergestellt, dass im Fall einer Kontakttrennung des Funktionselements 2 noch ein Stromfluss durch das Bauteil 1 auftritt. Das serielle verschaltete Sicherungselement 11 gewährleistet einen Minimalwiderstand des Bauteils 1 bei einem Kurzschluss des Funktionselements 2.

Beispielsweise sind beide Sicherungselemente 3, 11 als geeignet dimensionierte Drahtstücke oder ohmsche Widerstände ausgebildet. Insbesondere kann das Bauteil 1 als Kombination der Ausführungsformen der Figuren 2 und 6 vorliegen. Es können auch ein oder beide Sicherungselemente 3, 11 als Kaltleiter ausgebildet sein.

Die Sicherungselemente 3, 11 können zusätzlich zur Sicherungsfunktion auch ein Alarmsignal bereitstellen und/oder einen Fehlermodus initiieren. Falls der Gesamtwiderstand des Bauteils 1 dem Widerstand der Summe der Sicherungselemente 3, 11 entspricht, kann dies als Signal für den Ausfall des Funktionselements 2 interpretiert werden.

Die Figuren 8 bis 14 zeigen jeweils Widerstands-Temperatur-(R-T) Kennlinien von Ausführungsformen gemäß Figur 1, wobei ein Sicherungselement 3 parallel zu einem Funktionselement 2 verschaltet ist.

Figur 8 zeigt R-T-Kennlinien einer Ausführungsform gemäß Figur 1 in logarithmischer Darstellung. Beim Bauteil 1 handelt es sich insbesondere um einen NTC-Einschaltstrombegrenzer. Es ist ein Einsatzbereich von - 55°C bis 150°C dargestellt. Der vorgesehene Einsatzbereich kann beispielsweise auch von - 40°C bis 150°C oder von - 55°C bis 200°C oder von - 55°C bis 250°C reichen.

Bei einer Betriebstemperatur von 25°C weist das Funktionselement 2, d.h., das reine NTC-Element, einen Widerstand R_{F} = 40 Ohm auf. Der Widerstand des Funktionselements 2 nimmt bei steigender Temperatur T stark ab. Beispielsweise weist das Funktionselement 2 einen B_{25/100} Wert von ∼ 3500 K auf. Der B_{25/100} Wert ist ein Maß für die Steilheit der R-T-Kennlinie. Es kommen hier auch NTC-Elemente mit anderen B-Werten in Frage.

Es werden unterschiedlich dimensionierte Sicherungselemente 3 betrachtet. Die Sicherungselemente 3 sind als Ohmsche Widerstände mit R_{S600} =600 Ohm, R_{S200}=200 Ohm und R_{S100}=100 Ohm ausgebildet. Die tiefergestellte Zahl gibt jeweils den Widerstand des verwendeten Sicherungselements 3 an. Der Widerstand des jeweiligen Sicherungselements 3 ist im betrachteten Temperaturbereich von - 55°C bis 150°C weitgehend konstant.

Die Widerstände der betrachteten Sicherungselemente 3 sind bei einer Temperatur T=25°C deutlich größer als der Widerstand R_{F} des Funktionselements 2. Vorliegend sind die Widerstände R_{S} mehr als doppelt so groß wie der Widerstand des Funktionselements 2 bei 25°C.

Der Gesamtwiderstand des Bauteils 1 ist mit R_{tot,600} bzw. R_{tot,200} bzw. R_{tot,100} eingezeichnet, wobei die tiefergestellte Zahl jeweils den Widerstand des verwendeten Sicherungselements 3 angibt. Es ist ersichtlich, dass durch den Einsatz der Sicherungselemente 3 eine Linearisierung der Widerstandskennlinie erfolgt, die hier umso stärker ist, umso niedriger der Widerstand des Sicherungselements 3 ist. Beispielsweise wird das Sicherungselement 3 derart gewählt, dass sein Widerstand bei einer niedrigen Temperatur geringer ist als der Widerstand des Funktionselements 2. Vorliegend ist bei einer Temperatur von - 25°C der Widerstand R_{S100} niedriger als der Widerstand R_{F} (~110 Ohm).

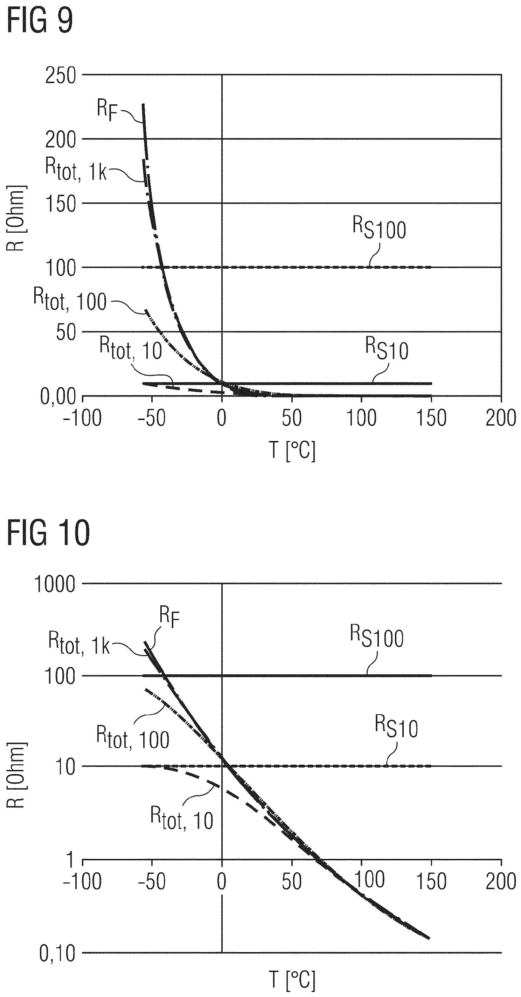

Die Figuren 9 und 10 zeigen R-T-Kennlinien weiterer Ausführungsformen gemäß Figur 1 in linearer und in einfach logarithmischer Darstellung, bei dem als Funktionselement 2 ein NTC-Element mit einem Widerstand R_{F} = 4,7 Ohm bei 25 °C eingesetzt ist. Der B_{25/100}-Wert liegt bei 3500 K. Als Sicherungselemente 3 werden ohmsche Widerstände mit R_{S} = 1kOhm, 100 Ohm und 10 Ohm eingesetzt.

Vorliegend sind bei 25 °C die Widerstände R_{S} mehr als doppelt so groß wie der Widerstand R_{F}. Bei T gleich - 25°C ist der Widerstand R_{S10} niedriger als der Widerstand R_{F}(∼42 Ohm), bei T = -55°C sind die Widerstände R_{S10} und R_{S100} niedriger als der Widerstand R_{F} (~228 Ohm).

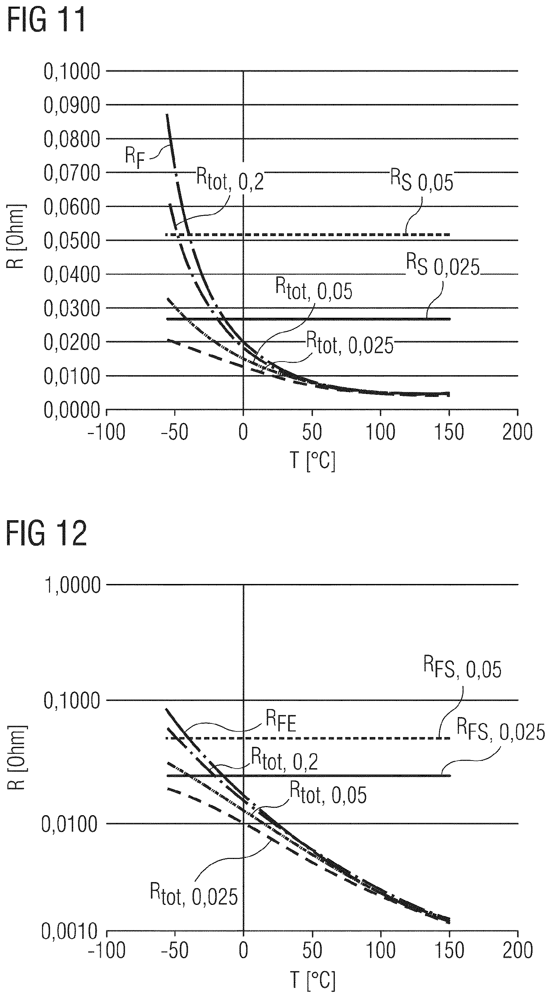

Die Figuren 11 und 12 zeigen R-T-Kennlinien weiterer Ausführungsformen gemäß Figur 1 in linearer und in einfach logarithmischer Darstellung, wobei als Funktionselement 2 ein NTC-Element mit einem Widerstand R_{F} = 0,01 Ohm bei 25 °C eingesetzt ist. Der B_{25/100}-Wert liegt bei 1500 K. Als Sicherungselemente 3 werden ohmsche Widerstände mit R_{S} = 0,2 Ohm, 0,05 Ohm und 0,025 Ohm betrachtet.

Auch hier sind bei 25 °C die Widerstände R_{S} mehr als doppelt so groß wie der Widerstand R_{F}. Bei T = -25°C ist der Widerstand R_{S0,025} niedriger als der Widerstand R_{F} (~0,033 Ohm), bei T = -55°C sind die Widerstände R_{S0,05} und R_{S0,025} niedriger als der Widerstand R_{F} (∼0,086 Ohm).

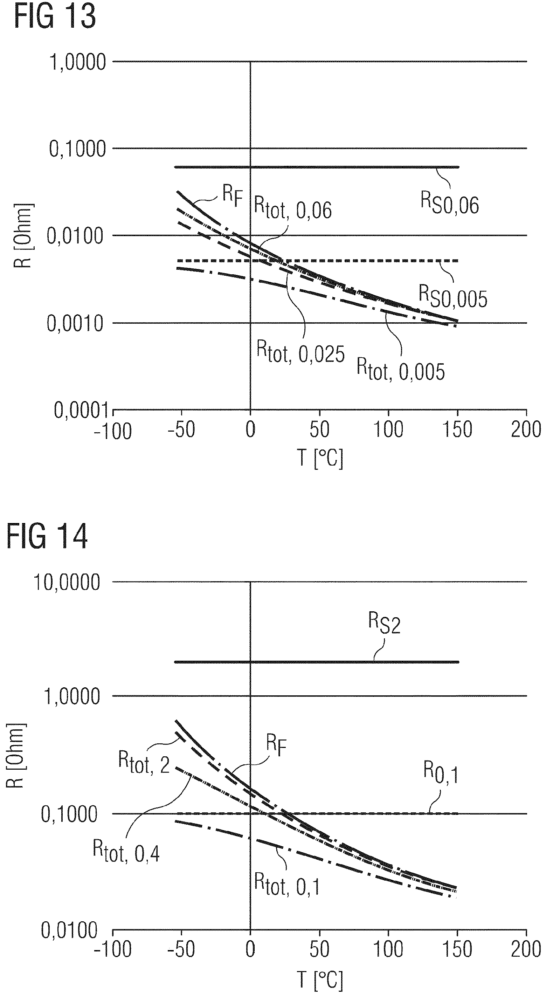

Figur 13 zeigt R-T-Kennlinien weiterer Ausführungsformen gemäß Figur 1 in einfach logarithmischer Darstellung, wobei als Funktionselement 2 ein NTC-Element mit einem Widerstand R_{F} = 0,005 Ohm bei 25°C eingesetzt ist. Der B_{25/100}-Wert liegt bei 1500 K. Für das Sicherungselement 2 werden ohmsche Widerstände mit R_{S} = 0,06 Ohm, 0,025 Ohm und 0,005 Ohm betrachtet.

Hier sind bei 25 °C die Widerstände R_{S} mindestens so groß wie der Widerstand R_{F}. Bei T = -25°C ist der Widerstand R_{S0,005} niedriger als der Widerstand R_{F} (~0,0138 Ohm), bei T = -55°C sind die Widerstände R_{S0,025} und R_{S0,005} niedriger als der Widerstand R_{F} (~0,0317 Ohm).

Ein Widerstand von 0,005 Ohm kann beispielsweise durch einen zylindrischen Eisendraht mit spezifischem Widerstand von 0,15 Ohm mm²/m bei einem Radius von 0,5 mm und einer Länge von 2,5 cm erreicht werden.

Figur 14 zeigt R-T-Kennlinien weiterer Ausführungsformen gemäß Figur 1 in einfach logarithmischer Darstellung, wobei als Funktionselement 2 ein NTC-Element mit einem Widerstand R_{F} = 0,1 Ohm bei 25°C eingesetzt ist. Der B_{25/100}-Wert liegt bei 1500 K. Für das Sicherungselement 2 werden ohmsche Widerstände mit R_{S} = 2 Ohm, 0,4 Ohm und 0,1 Ohm eingesetzt.

Hier sind bei 25 °C die Widerstände R_{S} mindestens so groß wie der Widerstand R_{F}. Bei T =-25 °C ist der Widerstand R_{S0,1} niedriger als der Widerstand R_{F} (~ 0,28 Ohm), bei T = -55°C sind die Widerstände R_{S0,4} und R_{S0,1} niedriger als der Widerstand R_{F} (~ 0,63 Ohm).

Figur 15 zeigt eine R-T-Kennlinie eines Funktionselements 2, das als PTC-Element, insbesondere als PTC-Thermistor, ausgebildet ist, in einfach logarithmischer Darstellung. Das PTC-Element ist beispielsweise für eine Arbeitstemperatur um die 100 °C geeignet.

Im Temperaturbereich von -40 °C bis 90 °C liegt der Widerstand des Funktionselements 2 bei ca. 10³ Ohm. Als Sicherungselement 3 wird beispielsweise ein Ohmscher Widerstand mit R_{S} = 10⁵ Ohm parallel geschaltet. In diesem Fall liegt der Widerstand des Bauteils 1 im Bereich von -40°C bis 90 °C bei ca. 990 Ohm.

Bei einer deutlichen Überhitzung, beispielsweise bei einer Temperatur von größer als 120 °C liegt der Widerstand des Funktionselements 2 bei ca. 10⁶ Ohm. Der Widerstand des Bauteils 1 liegt dann bei ca. 90 kOhm.

Bei einem Ausfall des Funktionselements 2 durch Kontakttrennung liegt der Widerstand des Bauteils 1 immer bei 10⁵ Ohm, so dass ein Mindestwiderstand gewährleistet ist.

Figur 16 zeigt eine Ausführungsform einer Bauteilanordnung 20 aufweisend mehrere miteinander verschaltete Bauteile 1, 21 gemäß Figur 1. Die Bauteile 1, 21 weisen jeweils ein Funktionselement 2, 22 auf. Beispielsweise sind beide Funktionselemente 2, 22 als PTC-Temperatursensoren ausgebildet. Durch die gezeigte serielle Verschaltung können Überhitzungen an mehreren Orten vermieden werden. Die Bauteilanordnung 20 kann auch als Bauteil mit mehreren Sicherungselementen 3, 23 und Funktionselementen 2, 22 angesehen werden.

Zu jedem Funktionselement 2, 22 ist ein Sicherungselement 3, 23 parallel verschaltet.

Durch geeignete Dimensionierung der Funktionselemente 2, 22 und der Sicherungselemente 3, 23 kann durch eine Messung des Gesamtwiderstands der Bauteilanordnung 20 ein Ausfall eines Funktionselements 2, 22 erkannt werden. Insbesondere kann zwischen einer Überhitzung und einem Ausfall eines Funktionselements 2, 22 unterschieden werden.

Die Widerstände der Sicherungselemente 3, 23 unterscheiden sich beispielsweise voneinander. Beispielsweise weist das erste Sicherungselement 3 einen Widerstand von 10⁴ Ohm auf und das zweite Sicherungselement 23 einen Widerstand von 10⁵ Ohm auf.

Beispielsweise weisen beide Funktionselemente 2, 22 die in Figur 15 gezeigte R-T-Kennlinie auf. Durch Messung des Gesamtwiderstands der Bauteilanordnung 20 kann erkannt werden, ob und welches Funktionselement 2, 22 ausgefallen ist.

Alternativ kann anstelle von zwei Sicherungselementen 3, 23 nur ein Sicherungselement 3 vorhanden sein, das mit beiden Funktionselementen 2, 22 parallel verschaltet ist. Dann werden bei einem Ausfall eines der Funktionselemente 2, 22 durch Kontaktbruch beide Funktionselemente 2, 22 durch das Sicherungselement 3 überbrückt und es wird ein Minimalstrom gewährleistet.

### Bezugszeichenliste

- 1: Bauteil
- 2: Funktionselement
- 3: Sicherungselement
- 4: Draht
- 5: Kontaktierung
- 6: Kontaktierung
- 7: Träger
- 8: Träger
- 9: Außenkontakt
- 10: Außenkontakt
- 11: Sicherungselement
- 12: Befestigungselement
- 13: Befestigungselement
- 14: Loch

- 20: Bauteilanordnung
- 21: weiteres Bauteil
- 22: weiteres Funktionselement
- 23: weiteres Sicherungselement

- Rₜₒₜ: Widerstand des Bauteils
- R_{F}: Widerstand des Funktionselements
- R_{S}: Widerstand des Sicherungselements

## Patentansprüche

1. Elektrisches Bauteil,
aufweisend ein Funktionselement (2, 22) und ein dazu elektrisch verschaltetes Sicherungselement (3, 11, 23), das bei einem Ausfall des Funktionselements (2, 22) einen Mindestwiderstand oder eine Mindestleitfähigkeit des Bauteils (1) gewährleistet,
**gekennzeichnet dadurch, dass** das Sicherungselement (3) als Träger (7) ausgebildet ist, wobei der Träger (7) die Form einer Stange aufweist, auf die das Funktionselement und Kontaktierungen (5, 6) des Funktionselements (2) aufgeschoben sind.

2. Bauteil nach Anspruch 1,
bei dem das Funktionselement (2, 22) als Kaltleiter oder Heißleiter ausgebildet ist.

3. Bauteil nach einem der Ansprüche 1 oder 2,
bei dem das Funktionselement (2, 22) als Einschaltstrombegrenzer oder als Temperatursensor ausgebildet ist.

4. Bauteil nach einem der vorhergehenden Ansprüche,
bei dem das Sicherungselement (3, 11, 23) parallel zum Funktionselement (2, 22) verschaltet ist.

5. Bauteil nach einem der vorhergehenden Ansprüche,
bei dem das Sicherungselement (3, 11, 23) seriell zum Funktionselement (2, 22) verschaltet ist.

6. Bauteil nach einem der vorhergehenden Ansprüche,
bei dem im Fall einer parallelen Verschaltung der Widerstand des Sicherungselements (3, 23) bei 25 °C mindestens doppelt so groß ist wie der Widerstand des Funktionselements (2) und im Fall einer seriellen Verschaltung der Widerstand des Sicherungselements (11) bei 25 °C höchstens halb so groß ist wie der Widerstand des Funktionselements (2).

7. Bauteil nach einem der vorhergehenden Ansprüche,
bei dem bei -40°C der Widerstand des Sicherungselements (3, 23) kleiner als der Widerstand des Funktionselements (2) ist.

8. Bauteil nach einem der vorhergehenden Ansprüche,
bei dem das Sicherungselement (3) zusätzlich zur Anzeige eines Ausfalls des Funktionselements (2) ausgebildet ist.

9. Bauteilanordnung aufweisend wenigstens zwei Bauteile (1) nach einem der vorhergehenden Ansprüche.

10. Verfahren zur Detektierung eines Ausfalls eines Funktionselements bei einem Bauteil oder einer Bauteilanordnung nach einem der Ansprüche 1 bis 9, aufweisend die Schritte:
A) Messen des Gesamtwiderstands des Bauteils (1)
B) Anzeigen eines Ausfalls, falls der Gesamtwiderstand einem errechneten Gesamtwiderstand bei Ausfall des Funktionselements (2) entspricht.

## Claims

1. Electric component,
comprising a functional element (2, 22) and a fail safe element (3, 11, 23) electrically interconnected therewith, said fail safe element ensuring a minimum resistance or a minimum conductivity of the component (1) in the event of a failure of the functional element (2, 22),
**characterized in that** the fail safe element (3) is embodied as a carrier (7), wherein the carrier (7) takes the form of a rod onto which the functional element and contacting facilities (5, 6) of the functional element (2) are pushed.

2. Component according to Claim 1,
wherein the functional element (2, 22) is embodied as a PTC thermistor or an NTC thermistor.

3. Component according to either of Claims 1 and 2, wherein the functional element (2, 22) is embodied as an inrush current limiter or as a temperature sensor.

4. Component according to any of the preceding claims, wherein the fail safe element (3, 11, 23) is interconnected in parallel with the functional element (2, 22).

5. Component according to any of the preceding claims, wherein the fail safe element (3, 11, 23) is interconnected in series with the functional element (2, 22).

6. Component according to any of the preceding claims, wherein, in the case of a parallel interconnection, the resistance of the fail safe element (3, 23) at 25°C is at least double the magnitude of the resistance of the functional element (2) and, in the case of a series interconnection, the resistance of the fail safe element (11) at 25°C is at most half the magnitude of the resistance of the functional element (2).

7. Component according to any of the preceding claims, wherein at -40°C the resistance of the fail safe element (3, 23) is less than the resistance of the functional element (2).

8. Component according to any of the preceding claims, wherein the fail safe element (3) is additionally configured for indicating a failure of the functional element (2).

9. Component arrangement having at least two components (1) according to any of the preceding claims.

10. Method for detecting a failure of a functional element in a component or a component arrangement according to any of Claims 1 to 9, comprising the following steps:
A) measuring the total resistance of the component (1),
B) indicating a failure if the total resistance corresponds to a calculated total resistance in the case of failure of the functional element (2).

## Revendications

1. Composant électrique,
comportant un élément fonctionnel (2, 22) et un élément de sécurité (3, 11, 23) branché électriquement, qui assure une résistance minimale ou une conductivité minimale du composant (1) en cas de défaillance de l'élément fonctionnel (2, 22),
**caractérisé en ce que** l'élément de sécurité (3) est formé comme un support (7), le support (7) comportant la forme d'une tige sur laquelle sont enfilés l'élément fonctionnel et des contacts (5, 6) de l'élément fonctionnel (2).

2. Composant selon la revendication 1,
dans lequel l'élément fonctionnel (2, 22) est formé comme une thermistance CTP ou une thermistance CTN.

3. Composant selon l'une des revendications 1 ou 2, dans lequel l'élément fonctionnel (2, 22) est formé comme un limiteur de courant d'appel ou comme un capteur de température.

4. Composant selon l'une des revendications précédentes,
dans lequel l'élément de sécurité (3, 11, 23) est branché en parallèle à l'élément fonctionnel (2, 22).

5. Composant selon l'une des revendications précédentes,
dans lequel l'élément de sécurité (3, 11, 23) est branché en série à l'élément fonctionnel (2, 22).

6. Composant selon l'une des revendications précédentes,
dans lequel, dans le cas d'un branchement parallèle, la résistance de l'élément de sécurité (3, 23) est à 25 °C au moins deux fois plus élevée que la résistance de l'élément fonctionnel (2) et, dans le cas d'un branchement en série, la résistance de l'élément de sécurité (11) est à 25 °C deux fois plus élevée au maximum que la résistance de l'élément fonctionnel (2).

7. Composant selon l'une des revendications précédentes,
dans lequel la résistance de l'élément de sécurité (3, 23) est à -40 °C inférieure à la résistance de l'élément fonctionnel (2).

8. Composant selon l'une des revendications précédentes,
dans lequel l'élément de sécurité (3) est formé en supplément pour l'indication d'une défaillance de l'élément fonctionnel (2).

9. Ensemble de composants comprenant au moins deux composants (1) selon l'une des revendications précédentes.

10. Procédé de détection d'une défaillance d'un élément fonctionnel dans un composant ou un ensemble de composants selon l'une des revendications 1 à 9, comportant les étapes :
A) mesure de la résistance totale du composant (1)
B) indication d'une défaillance si la résistance totale correspond à une résistance totale calculée en cas de défaillance de l'élément fonctionnel (2).
